# EUROPÄISCHE PATENTANMELDUNG

(11) **EP 0 652 698 A1**
(43) Veröffentlichungstag der Anmeldung: **10.05.1995**
(21) Anmeldenummer: 94203150.1
(22) Anmeldetag: 28.10.1994
(51) Int. Cl.: H05K 13/00, B65G 17/32

(54) **Anordnung zum Transportieren von gedruckten Schaltungsplatten**

(30) Priorität: 05.11.1993 DE 4337811
(71) Anmelder: Philips Patentverwaltung GmbH, 22335 Hamburg (DE); Philips Electronics N.V., 5621 BA Eindhoven (NL)
(72) Erfinder: Barth, Klaus, c/o Philips Patentverwaltung GmbH, D-20097 Hamburg (DE)
(74) Vertreter: Erdmann, Anton, Dipl.-Ing.

(57) **Zusammenfassung**

Die Erfindung bezieht sich auf eine Anordnung zum Transportieren von gedruckten Schaltungsplatten (7), wie Prints oder Substraten, während ihrer Bestückung auf einer Transportstreckenführung zwischen und/oder in den verschiedenen Bearbeitungsstationen, wobei die Schaltungsplatten in einer definierten Stellung gehandhabt werden, mit
- einer Transportkette (3), an der im Abstand von mehreren Kettengliedern (3c) Haltevorrichtungen (3d) für einzelne Schaltungsplatten (7) angeordnet sind,
- an den Schaltungsplatten (7) vorgesehenen, schaltungsmäßig inaktiven, abtrennbaren Transportstreifen (7b) des Plattenmaterials, die von den Haltevorrichtungen (3d) zum Transport mit der sich bewegenden Transportkette (3) erfaßbar sind.

## Beschreibung

Die Erfindung bezieht sich auf eine Anordnung zum Transportieren von gedruckten Schaltungsplatten, wie Prints oder Substraten, während ihrer Bestückung auf einer Transportstreckenführung zwischen und/oder in den verschiedenen Bearbeitungsstationen, wobei die Schaltungsplatten in einer definierten Stellung gehandhabt werden.

Zum Transportieren von Schaltungsplatten ist es bekannt, diese auf einen sogenannten Carrier zu legen und den Carrier mit Schaltungsplatte dann auf einem Transportband von Bearbeitungsstation zu Bearbeitungsstation zu fördern. Um die Carrier besser auszunutzen, werden mehrere Schaltungsplatten zu einem Nutzen zusammengefaßt, aus dem dann später die einzelnen Schaltungsplatten herausgeschnitten werden.

Der Einsatz von Nutzen ist nicht flexibel genug. Soll eine der Schaltungsplatten eines Nutzens in ihren Außendimensionen variiert werden, dann ist der ganze Nutzen hinfällig, weil nur er auf den Carrier paßt.

Es ist Aufgabe der Erfindung, eine Anordnung zum Transportieren von Schaltungsplatten zu schaffen, die flexibler ist und bei der Schaltungsplatten kurzfristig geändert werden können.

Die gestellte Aufgabe ist bei einer Anordnung der eingangs erwähnten Art erfindungsgemäß gelöst durch
- eine Transportkette, an der im Abstand von mehreren Kettengliedern Haltevorrichtungen für einzelne Schaltungsplatten angeordnet sind,
- an den Schaltungsplatten vorgesehene, schaltungsmäßig inaktive, abtrennbare Transportstreifen des Plattenmaterials, die von den Haltevorrichtungen zum Transport mit der sich bewegenden Transportkette erfaßbar sind.

Wenn die Transportkette mit Halterungen versehen ist, die Schaltungsplatten einzeln erfassen können, dann sind die äußeren Dimensionen der Schaltungsplatten in weiten Grenzen variabel. Es werden keine speziellen Carrier mehr benötigt, denen Nutzen mit festen Außendimensionen zugeordnet sind.

Nach einer weiteren Ausgestaltung der Erfindung ist vorgesehen, daß die Haltevorrichtung aus einer Klemme besteht, in die der Transportstreifen einer Schaltungsplatte zum freitragenden Transport mit der Kette einschiebbar und zur Weiterbehandlung an einer anderen Stelle herausziehbar ist. Eine solche Klemmung ist eine einfache Art der Befestigung, die aber zum Transport voll ausreicht.

Nach einer weiteren Ausgestaltung der Erfindung ist vorgesehen, daß die Haltevorrichtung aus einer Auflage mit nach oben vorstehenden Stiften besteht, auf die die Schaltungsplatte mit den Stiften zugeordneten Löchern auflegbar ist zum liegenden Transportieren. In diesem Fall wird es möglich, auch mehrere Schaltungsplatten einzeln nebeneinander auf den Auflagen zu verwenden, beispielsweise wenn in einem Reflow-Ofen eine größere Durchfahrbreite zur Verfügung steht, die ausgenutzt werden muß.

Nach einer weiteren Ausgestaltung der Erfindung ist vorgesehen, daß die Auflagen von parallel zueinander angeordneten Transportketten getragen werden.

Nach einer weiteren Ausgestaltung der Erfindung ist vorgesehen, daß die Streckenführung der Transportkette zwischen zwei aufeinander folgenden Bearbeitungsstationen eine Puffervorrichtung aufweist, in deren Bereich die Streckenführung so verändert wird, daß sich die Länge des Transportweges an die gewünschte Transportzeit anpaßt. Der Kettentransport einzelner Schaltungsplatten ermöglicht, die Flexibilität der Transportanordnung zu vergrößern.

Die Puffervorrichtung der Anordnung kann dabei derart ausgebildet sein, daß an einer Transportvorrichtung, mittels der die Transportkette längs einer geradlinigen Transportstrecke zwischen den Produktionsstellen als Kettenschleife mit Vor- und Rücklauftrumm geführt ist, eine Ausgleichvorrichtung vorgesehen ist, die aus einem quer zur Transportstrecke verschieblichen Ausgleichsbalken besteht, der an seinen Enden Umlenkräder aufweist, über die die Transportkette, die beiderseits des Ausgleichsbalkens in dessen Längsrichtung umgelenkt wird, geführt ist. Mit dem Ausgleichsbalken lassen sich Fertigungsunterbrechungen ausgleichen, indem die von der Transportkette gehaltenen Schaltungsplatten bei Bedarf mehr oder weniger auf den Ausgleichsbalken auflaufen.

Nach einer weiteren Ausgestaltung der Erfindung ist vorgesehen, daß die Bewegungsgeschwindigkeit der Transportkette, die beim jeweiligen Übergang vom Vor- zum Rücklauftrumm und umgekehrt als Schleife über Kettentransporträder geführt ist, mittels getrennt auf die Kettentransporträder wirkender Antriebe am Anfang und am Ende der Transportstrecke unabhängig voneinander einstellbar ist. Mit den Antrieben läßt sich der Schaltungsplattentransport an die Gegebenheiten von Fertigungsstörungen in den einzelnen Bearbeitungsstationen anpassen. Kommen aus einer Bearbeitungsstation keine Schaltungsplatten heraus, dann bleibt dieser Antrieb stehen, und der andere Antrieb sorgt dafür, daß auf der Transportkette noch vorhandene Schaltungsplatten der nachfolgenden Bearbeitungsstation zugeführt werden. Besteht ein Abnahmefehler bei der nachfolgenden Bearbeitungsstation, dann bleibt der Antrieb an deren Seite stehen, und der Antrieb auf der Seite der vorangehenden Bearbeitungsstation belädt die Transportkette trotz fehlender Abnahme auf der Abnahmeseite. Ein solcher Ausgleich ist zweckmäßig und wirkungsvoll.

Nach einer weiteren Ausgestaltung der Erfindung ist vorgesehen, daß ein Zwischenlager vorgesehen ist, in dem ein Roboter Schaltungsplatten zwischenlagern kann, wobei das Zwischenlager aus lagenweise übereinander angeordneten Klemmstreifen besteht.
Die Erfindung wird anhand der Zeichnung näher erläutert.
Es zeigen:
Fig. 1 einen Ausschnitt aus einer Anordnung zum Transportieren von einzelnen Schaltungsplatten mit einer in Schleifenform geführten Transportkette, die mit einzelnen Schaltungsplatten bestückt ist,
Fig. 2 eine Klemmvorrichtung zum Anklemmen von Schaltungsplatten an die Transportkette,
Fig. 3 eine Schaltungsplatte für die Transportvorrichtung mit einem inaktiven, dem Festklemmen dienenden Plattenstreifen,
Fig. 4 eine Abwandlung der Transportvorrichtung mit zwei parallelen Transportketten und Auflagestreifen für den Transport in Trockenöfen und Reflowöfen,
Fig. 5 eine Pufferstation im Verlauf einer Transportkettenschleife mit einem quer verschiebbaren Ausgleichsbalken,
Fig. 6 und 7 den Ausgleichsbalken im Gegensatz zu Fig. 3 in zwei abgestuft, geringer nach oben herausragenden Höhen, wobei die Speicherkapazität zwischen den Bearbeitungsstationen von Fig. 5 zu Fig. 6 zu Fig. 7 abnimmt,
Fig. 8 eine andere Art einer Pufferstation mit Klemmitteln und einem Teil eines Roboters, mit dem die Schaltungsplatten gehandhabt werden können.

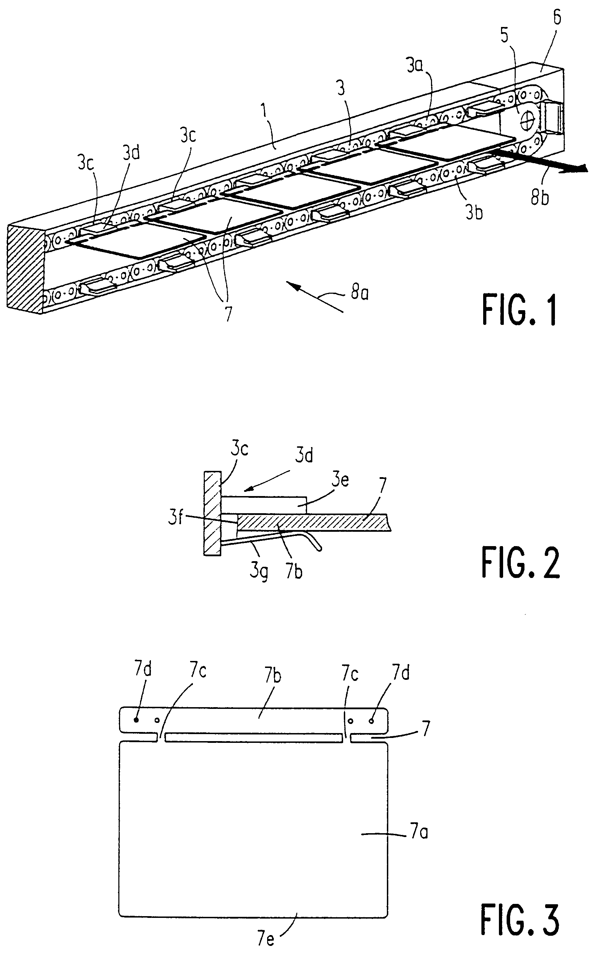

Fig. 1 zeigt eine Transportvorrichtung 1, in der eine Transportkette 3 mit einem oberen Trumm 3a und einem unteren Trumm 3b als Endlosschleife umläuft. An den Enden 6 der Transportvorrichtung 1 ist die Transportkette 3 über Antriebsräder 5 geführt. Dies ist im rechten Teil des Bildes erkennbar, der linke Teil der Transportvorrichtung 1 ist abgeschnitten und nicht dargestellt; er ist aber entsprechend dem rechten Ende 6 ausgebildet.

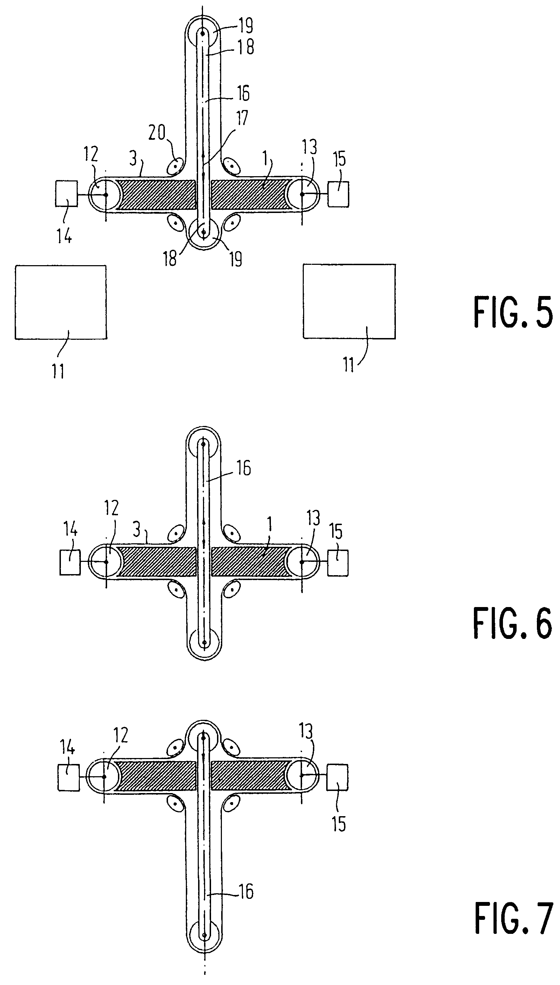

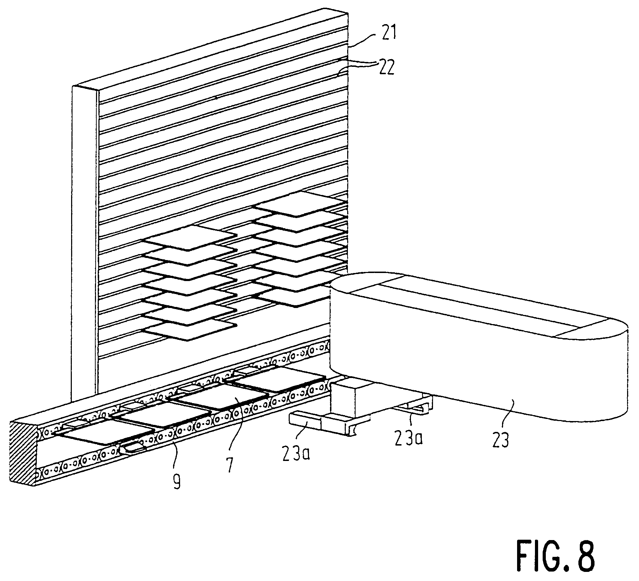

Die Transportvorrichtung 1 mit der Transportkette 3 wird zwischen Bearbeitungsstationen 11 angeordnet, die in Fig. 5 schematisch angedeutet sind. Im Bereich der Bearbeitungsstationen 11 sind Übergaberoboter 23 (angedeutet in Fig. 8) vorgesehen, die Schaltungsplatten 7 von einer vorangehenden Bearbeitungsstation an die Transportkette anklemmen (angedeutet durch Pfeil 8a in Fig. 1). Am anderen Ende 6 der Transportvorrichtung 1 befindet sich wieder ein Roboter 23, der die Schaltungsplatten 7 von der Transportkette abnimmt und der nächsten Bearbeitungsstation zuführt (angedeutet durch Pfeil 8b in Fig. 1).

Wie aus Fig. 1 zu ersehen ist, sind zum Anstecken der Schaltungsplatten 7 an einzelnen Kettengliedern 3c Klemmvorrichtungen 3d vorgesehen. Jede Klemmvorrichtung besteht, wie sich aus Fig. 2 vergrößert ergibt, aus einer Anlageplatte 3e mit einem Anschlag 3f und einer Andruckfeder 3g. Die Schaltungsplatten 7 werden zwischen der oberen Anschlagplatte 3e und der unten gelegenen Andruckfeder 3g festgeklemmt.

Fig. 3 zeigt die Ausbildung der Schaltungsplatten 7. Diese bestehen aus einem aktiven Plattenteil 7a und einem inaktiven Streifen 7b. Der inaktive Streifen 7b wird in die Klemmvorrichtungen 3d eingesteckt. Der inaktive Streifen 7b ist nur über Stegverbindungen 7c mit dem aktiven Plattenteil 7a verbunden.

Zu dem normalen Transportieren von Schaltungsplatten von einer Bearbeitungsstation 11 zur nächsten wird die in Fig. 1 dargestellte Kettentransportvorrichtung 1 in geradlinig gestreckter Form eingesetzt. Es kann aber in besonderen Fällen auch erforderlich sein, gleichzeitig nebeneinander mehrere Schaltungsplatten 7 zu bewegen, wenn diese beispielsweise nach einer vollständigen Bestückung in einem Hitzeofen (Reflow-Ofen) verlötet werden sollen, wobei die Lötpaste aufschmilzt und die erforderlichen Lötungen an den Pastenauftragsstellen erfolgen.

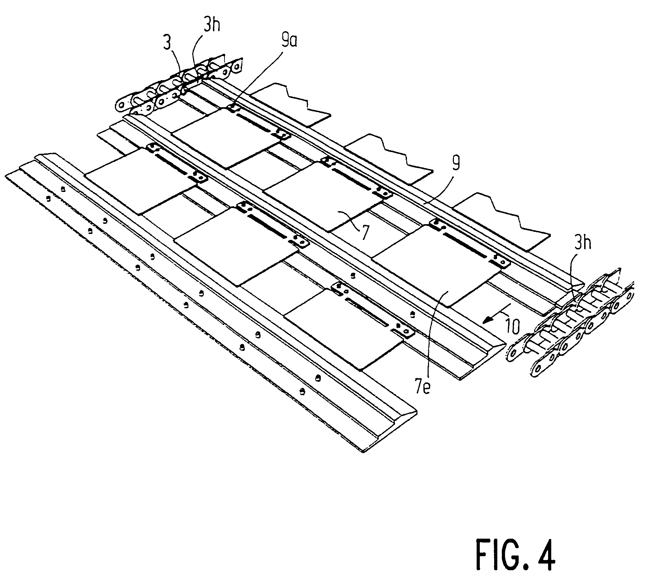

In so einem Fall ist vorgesehen, die Transportvorrichtung aus zwei parallelen Kettenschleifen 3 zu bilden, wie in Fig. 4 dargestellt ist. Zwischen diesen Kettenschleifen 3 werden von Kettengliedern 3h Tragstreifen 9 gehalten. Diese Tragstreifen 9 sind mit nach oben vorstehenden Stiften 9a versehen. Die Schaltungsplatten 7 sind im Bereich ihrer inaktiven Streifen 7b mit den Stiften 9a zugeordneten Löchern 7d versehen. Außerdem sind die Tragstreifen 9 in Transportrichtung entsprechend Pfeil 10 in einem solchen Abstand voneinander angeordnet, daß die dem inaktiven Streifen 7b gegenüberliegende Schaltungsplattenkante 7e auf dem benachbarten Tragstreifen 9 aufliegen kann. Von einem nicht dargestellten Roboter werden mehrere Schaltungsplatten 7 nebeneinander auf die Stifte 9a gelegt, wobei die Platten dann gegen ein Verrutschen gesichert sind und am inaktiven Streifen 7b und an der Kante 7e aufliegen. Auf diese Weise können mehrere Schaltungsplatten 7 nebeneinander einer Bearbeitung zugeführt werden.

Selbstverständlich ist es möglich, die Auflagen auch für einzelne Schaltungsplatten 7 vorzusehen. Dies wird aber nur in speziellen Fällen zweckmäßig sein, da der Aufwand größer ist als bei den Klemmvorrichtungen 3d.

Die Verwendung von Transportketten 3 zum Transportieren von einzelnen Schaltungsplatten eröffnet aufgrund der Flexibilität der Transportketten 3die Möglichkeit der Anordnung einer Puffervorrichtung. Eine solche Puffervorrichtung ist in den Fig. 5, 6 und 7 dargestellt. Es wird wieder ausgegangen von der Transportvorrichtung 1 mit der Transportkette 3, die als Endlosschleife ausgebildet ist. Die Transportvorrichtung 1 ist im Bereich der in Fig. 4 mit Kästchen angedeuteten Bearbeitungsstationen 11 mit umlaufenden Antriebsrädern 12 und 13 versehen, die mittels schematisch dargestellter Antriebsmotoren 14, 15 unabhängig voneinander antreib- oder stillsetzbar sind. Quer zu der Transportvorrichtung 1 erstreckt sich ein vertikaler Ausgleichsbalken 16, der in Richtung eines Doppelpfeiles 17 auf- und abfahrbar ist entsprechend den von den Motoren 14 bzw. 15 vorgegebenen Antriebsbewegungen. Der Ausgleichsbalken 16 ist an seinen Enden 18 mit Umlenkrädern 19 versehen. Die Transportkette 3 wird zwischen den Transporträdern 12 und 13 über Ausgleichsräder 20 in eine Parallelrichtung zum Ausgleichsbalken 20 umgelenkt und ist an den Enden 18 über die Umlenkräder 19 geführt.

Wie bei der Darstellung nach Fig. 1 können Klemmvorrichtungen 3d die Schaltungsplatten 7 auf der Kette 3 mit der Kette auch in den Bereich des Ausgleichsbalkens 16 überführen. Damit läßt sich eine Pufferwirkung erzielen. Es sei angenommen, daß der Antriebsmotor 14 das Antriebsrad 15 dreht und ein Roboter 23 auf die Transportkette 3 Schaltungsplatten 7 bei laufender Kette 3 aufsteckt. Wird nun infolge einer Störung an der rechten Bearbeitungsstation 11 das Antriebsrad 13 durch Stillsetzen des Motors 15 angehalten, dann wird der Ausgleichsbalken 16 nach oben bewegt, und die Schaltungsplatten 7 wandern nicht gleich zu der rechten Bearbeitungsstation 11, sondern erst einmal bei nach oben wanderndem Ausgleichsbalken 16 mit nach oben. In Fig. 5 ist dargestellt, daß der Ausgleichsbalken sich ganz nach oben geschoben hat.

In Fig. 6 ist nun dargestellt, was passiert, wenn der Antriebsmotor 15 wieder in Bewegung gesetzt wird. Bei gleicher Drehgeschwindigkeit der Motoren 14 und 15 bleibt der Ausgleichsbalken oben stehen, und die Schaltungsplatten laufen über den hochgeschobenen Ausgleichsbalken weiter zur rechten Bearbeitungsstation. In Fig. 6 ist dargestellt, was passiert, wenn eine Störung an der linken vorhergehenden Bearbeitungsstation 11 auftritt. Dann bleibt der Motor 14 stehen, und das Antriebsrad 12 setzt die Transportkette 3 im linken Teil der Transportvorrichtung 1 fest. Nun zieht der Antriebsmotor 15 über das Antriebsrad 13 die Kette 3 aber weiter. Der Ausgleichsbalken 16 sinkt ab, wobei der Roboter 23 die auf der Kette befindlichen Schaltungsplatten 7 in Richtung des Pfeiles 8b abnehmen kann. Das Absenken geht so weit, bis, wie in der Darstellung nach Fig. 7 gezeigt, der Ausgleichsbalken 16 völlig nach unten gewandert ist. Wenn nun die Störung an der vorangegangenen, links dargestellten Bearbeitungsstation nicht beendet ist, muß die Transportvorrichtung 1 stillgesetzt werden.

In Fig. 8 ist eine weitere Ausführungsform einer Pufferstation dargestellt. Diese Pufferstation besteht aus einem Rahmen 21 mit parallel übereinander angeordneten Klemmleisten 22. Im Falle von Produktionsstörungen kann ein Roboter 23 mit seinen Greifarmen 23a Schaltungsplatten 7 von der Transportkette abnehmen und in die Klemmschienen 22 einstecken, wie es in Fig. 2 dargestellt ist. Beim Ende der Transportstörung, oder wenn die Zwischenaufbewahrung aus einem anderen Grunde aufgehoben werden soll, werden die Schaltungsplatten vom Roboter wieder auf die Transportvorrichtung 1 zurückgesetzt.

## Patentansprüche

1. Anordnung zum Transportieren von gedruckten Schaltungsplatten (7), wie Prints oder Substraten, während ihrer Bestückung auf einer Transportstreckenführung zwischen und/oder in den verschiedenen Bearbeitungsstationen, wobei die Schaltungsplatten in einer definierten Stellung gehandhabt werden,
gekennzeichnet durch
- eine Transportkette (3), an der im Abstand von mehreren Kettengliedern (3c) Haltevorrichtungen (3d) für einzelne Schaltungsplatten (7) angeordnet sind,
- an den Schaltungsplatten (7) vorgesehene, schaltungsmäßig inaktive, abtrennbare Transportstreifen (7b) des Plattenmaterials, die von den Haltevorrichtungen (3d) zum Transport mit der sich bewegenden Transportkette (3) erfaßbar sind.

2. Anordnung nach Anspruch 1, dadurch gekennzeichnet, daß die Haltevorrichtung (3d) aus einer Klemme (3e, 3g) besteht, in die der Transportstreifen (7b) einer schaltungsplatte (7) zum freitragenden Transport mit der Kette (3) einschiebbar und zur Weiterbehandlung an einer anderen Stelle herausziehbar ist.

3. Anordnung nach Anspruch 1, dadurch gekennzeichnet, daß die Haltevorrichtung aus einer Auflage (9) mit nach oben vorstehenden Stiften (9a) besteht, auf die die Schaltungsplatte (7) mit den Stiften (9a) zugeordneten Löchern (7d) auflegbar ist zum liegenden Transportieren.

4. Anordnung nach Anspruch 3, dadurch gekennzeichnet, daß die Auflagen (9) von parallel zueinander angeordneten Transportketten (3) gehalten werden.

5. Anordnung nach Anspruch 1, dadurch gekennzeichnet, daß die Streckenführung der Transportkette (3) zwischen zwei aufeinander folgenden Bearbeitungsstationen eine Puffervorrichtung aufweist, in deren Bereich die Streckenführung so verändert wird, daß sich die Länge des Transportweges an die gewünschte Transportzeit anpaßt.

6. Anordnung nach Anspruch 5, dadurch gekennzeichnet, daß an einer Transportvorrichtung (1), mittels der die Transportkette (3) längs einer geradlinigen Transportstrecke zwischen den Bearbeitungsstationen (11) als Kettenschleife mit Vor- und Rücklauftrumm (3a, 3b) geführt ist, eine Ausgleichvorrichtung vorgesehen ist, die aus einem quer zur Transportstrecke verschieblichen Ausgleichsbalken (16) besteht, der an seinen Enden (18) Umlenkräder (19) aufweist, über die die Transportkette (3), die beiderseits des Ausgleichsbalkens (16) in dessen Längsrichtung umgelenkt wird, geführt ist.

7. Anordnung nach Anspruch 6, dadurch gekennzeichnet, daß die Bewegunggeschwindigkeit der Transportkette (3), die beim jeweiligen Übergang vom Vor- zum Rücklauftrumm und umgekehrt als Schleife über Kettenantriebsräder (12, 13) geführt ist, mittels getrennt auf die Kettenantriebsräder wirkender Antriebe (14, 15) am Anfang und am Ende der Transportstrecke unabhängig voneinander einstellbar ist.

8. Anordnung nach einem oder mehreren der Ansprüche 1 bis 4, dadurch gekennzeichnet, daß ein Zwischenlager (21) vorgesehen ist, in dem ein Roboter (23) Schaltungsplatten (7) zwischenlagern kann, wobei das Zwischenlager (21) aus lagenweise übereinander angeordneten Klemmstreifen (22) besteht.
